Europäisches Patentamt

European Patent Office

Office européen des brevets

(19)

(11) **EP 1 329 695 B1**

(12) **FASCICULE DE BREVET EUROPEEN**

(45) Date de publication et mention
de la délivrance du brevet:
**05.10.2005 Bulletin 2005/40**

(51) Int Cl.⁷: **G01D 5/16**, G01B 7/00

(21) Numéro de dépôt: **03100897.2**

(22) Date de dépôt: **09.05.1997**

(54) **Capteur de type magnétorésistif pour mesure de dimension**

Magnetoresistiver Sensor für Dimensionsbestimmung

Magnetoresistance sensor for measuring dimensions

(84) Etats contractants désignés:
**CH DE FR GB LI**

(43) Date de publication de la demande:
**23.07.2003 Bulletin 2003/30**

(62) Numéro(s) de document de la (des) demande(s)
initiale(s) en application de l'article 76 CBE:
**97810290.3 / 0 877 228**

(73) Titulaire: **TESA SA**
**1020 Renens (CH)**

(72) Inventeurs:
• **Bezinge, Alex**
**2207, Coffrane (CH)**

• **Bolli, Jean-Luc**
**1202, Genève (CH)**

(74) Mandataire: **P&TS**
**Patents & Technology Surveys SA**
**Terreaux 7**
**P.O.Box 2848**
**2001 Neuchâtel (CH)**

(56) Documents cités:
**EP-A- 0 306 178**    **EP-A- 0 554 518**
**EP-A- 0 624 778**    **EP-A- 0 784 199**
**DE-A- 4 208 927**    **DE-A- 4 233 331**
**US-A- 4 319 188**    **US-A- 4 594 548**
**US-A- 4 845 456**    **US-A- 5 036 276**
**US-A- 5 521 501**

EP 1 329 695 B1

**Description**

La présente invention concerne un capteur de type magnétorésistif selon le préambule de la revendication 1, et un dispositif de mesure de dimensions comportant un tel capteur. Plus précisément, l'invention concerne la disposition des électrodes magnétorésistives dans un capteur de type magnétorésistif.

Des dispositifs électroniques de mesure de longueur ou de position angulaire en milieu industriel par exemple doivent généralement satisfaire plusieurs contraintes partiellement contradictoires. Ils doivent fournir une précision et une résolution suffisante, et être utilisables dans des environnements soumis à des vibrations ou à des pollutions telles que poussière, huile ou humidité. On attend également de ces capteurs une intégration aisée dans des appareils de faible volume, sans réglages ou adaptations importants, une vitesse de mesure élevée et une consommation électrique aussi réduite que possible.

Différents types de dispositifs de mesure, basés sur différents principes physiques, ont été mis au point pour satisfaire ces exigences diverses. En particulier, des systèmes de mesure utilisant les variations de capacité provoquées par le déplacement d'un capteur en regard d'une règle ont été abondamment utilisés en particulier dans des dispositifs portables tels que calibres par exemple. Ces dispositifs doivent être maintenus assez propres pour fonctionner et sont donc mal adaptés à un fonctionnement dans un environnement humide ou sujet aux projections de lubrifiant ou d'huile de coupe par exemple. Des dispositifs de mesure de longueur basés sur le principe d'électrodes magnétorésistives ont été proposés par exemple dans le document de brevet DE4233331 (IMO), qui offrent une résistance bien supérieure aux salissures. Le dispositif décrit dans ce document comprend un capteur muni d'un réseau d'électrodes magnétorésistives reliées de manière à définir deux ponts de mesure. Les électrodes sont disposées et reliées de manière à ce que toutes les pistes se trouvent dans le même plan, c'est-à-dire qu'aucun croisement de pistes n'est nécessaire. Le capteur est monté sur un coulisseau et peut être déplacé face à une règle magnétisée avec une période de magnétisation λ. Les électrodes magnétorésistives du capteur sont étalées sur une longueur égale à deux périodes de la règle. Un déplacement du capteur face à la règle provoque une modification du champ magnétique appliqué sur les diverses électrodes magnétorésistives du capteur, et donc une modification de leur résistance. En mettant les ponts de mesure sous tension, on récolte à leur sortie un signal électrique fonction périodique de la position du capteur le long de la règle.

Les deux ponts de mesure sont constitués de quatre électrodes magnétorésistives déphasées de λ/2. Les électrodes correspondantes de chaque pont occupent des positions déphasées de λ/4. Les électrodes des deux ponts sont entremêlées. Ce document suggère en outre l'utilisation de structures de barberpoles. La théorie générale des structures de barberpole a été expliquée par F. Dettmann et U. Loreit au cours du symposium « Magnetoresistive Sensoren, Grundlagen, Herstellung, Anwendung » qui s'est tenu à Dortmund le 25 juin 1992. Les structures de barberpole sont obtenues en appliquant sur les électrodes magnétorésistives de fines bandes parallèles de matériau conducteur inclinées de 45° environ par rapport à l'axe des électrodes. Ces bandes conductrices constituent des lignes équipotentielles ; entre les bandes, le courant emprunte le chemin le plus court et circule donc avec une inclinaison de 45° par rapport à l'axe des électrodes magnétorésistives. Cette structure permet de modifier la direction du vecteur de courant I. Comme la résistance d'une électrode magnétorésistive est fonction de l'angle entre le vecteur d'aimantation et le vecteur de courant, les structures de barberpole permettent de contrôler le sens et l'amplitude de la variation de résistance des électrodes provoquée par le déplacement du capteur.

Chaque branche du pont de mesure est constituée par une seule électrode magnétorésistive dont la largeur doit être suffisante pour réagir aux champs magnétiques relativement peu importants générés par la règle. La résistance des branches du pont est donc réduite, et des courants importants circulent à travers les ponts de mesure. La consommation électrique de ce dispositif est par conséquent importante.

Le brevet US 4845456 A décrit un capteur magnétique de déplacement comprenant un pont de mesure formé par des électrodes magnétorésistives. Les électrodes magnétorésistives sont réalisées par deux ou trois parties disposées à une distance prédéterminée et reliées par des conducteurs de faible résistivité.

Un but de l'invention est de réaliser un capteur de type magnétorésistif pour dispositif de mesure de longueur et/ou d'angle amélioré par rapport aux dispositifs de l'art antérieur. En particulier, un but de la présente invention est de réaliser un capteur de type magnétorésistif qui permette des mesures de haute précision avec une haute sensibilité et une faible consommation énergétique. Un autre but est de réaliser un capteur magnétorésistif aisément intégrable dans un dispositif de mesure existant.

Selon l'invention, ces buts sont atteints au moyen d'un dispositif présentant les éléments de la partie caractérisante de la revendication 1, des variantes étant en outre indiquées dans les revendications dépendantes.

L'invention sera mieux comprise à la lecture de la description donnée à titre d'exemple et illustrée par les figures suivantes:

La figure 1 représente une vue schématique en perspective d'une portion de règle et d'une portion de capteur, plusieurs groupes d'électrodes magnétorésistives étant visibles sur ladite portion de capteur, la figure illustrant en outre le champ magnétique H produit par la portion de règle sur la portion de capteur.

La figure 2 montre un schéma électrique illustrant la manière dont les différentes électrodes de règle sont connectées de manière à constituer deux ponts de mesure.

La figure 3 illustre de manière schématique la répartition spatiale des électrodes magnétorésistives de capteur en groupes.

La figure 4 illustre de manière schématique la disposition des électrodes magnétorésistives à l'intérieur d'un groupe.

La figure 5 illustre de manière schématique l'effet de moyennage obtenu grâce aux groupes d'électrodes.

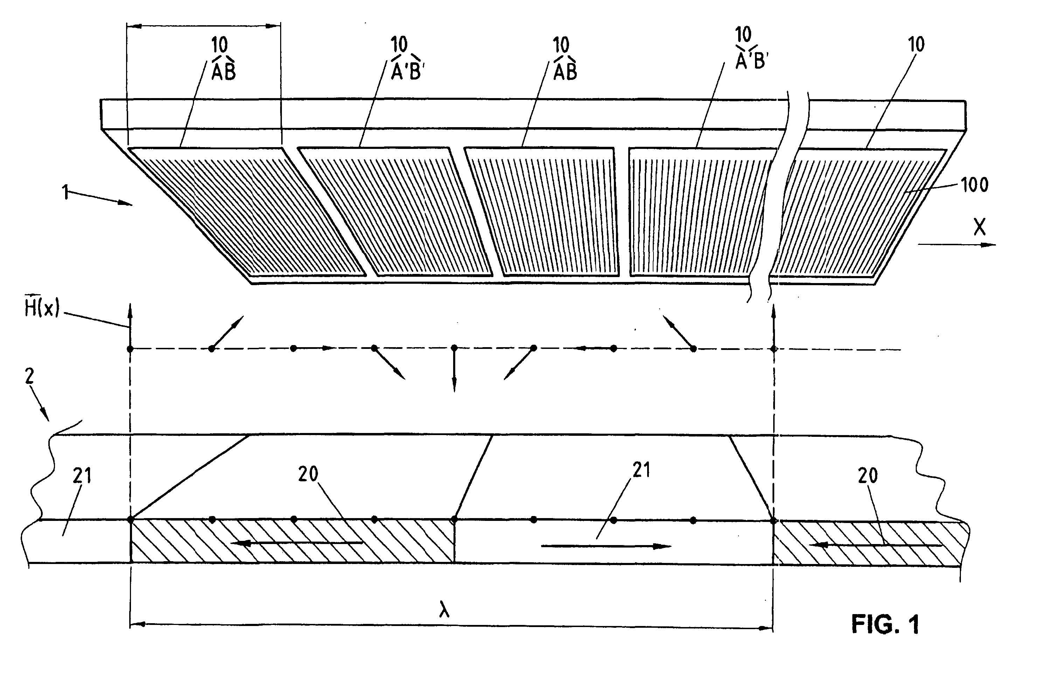

La figure 1 illustre de manière schématique une portion de capteur 1 au-dessus d'une portion de règle 2. La règle comporte une magnétisation périodique selon la direction horizontale x et -x. La période de magnétisation, ou période de règle, vaut $\lambda$, c'est-à-dire que la longueur des segments 20, 21 magnétisés dans une direction déterminée vaut $\lambda/2$.

La règle 2 est de préférence fixe par rapport à l'ensemble du dispositif de mesure, alors que le capteur magnétorésistif 1 peut se déplacer à faible distance au-dessus de la règle. Dans le cas où le dispositif de mesure constitue une colonne de mesure ou un pied à coulisse, la règle 2 est solidaire du bâti ou de la règle du dispositif, alors que le capteur 1 est associé à un coulisseau pouvant coulisser le long du bâti ou de la règle. La longueur du capteur est typiquement de l'ordre de quelques centimètres contre plusieurs dizaines de centimètres pour la règle. D'autres dispositions, en particulier une inversion de la règle et du capteur, sont aussi possibles. Dans le cas d'un dispositif de mesure d'angle ou de rotation d'un axe, la règle peut être constituée par un réseau d'électrodes sur la périphérie d'un axe, et le capteur placé à l'intérieur d'une bague cylindrique autour de cet axe.

La règle peut par exemple être réalisée par une bande d'aluminium sur laquelle est déposé un matériau à haute coercitivité magnétique (ferrites). A la surface de la règle, le champ magnétique horizontal $H_x(x)$ est une fonction pratiquement rectangulaire de la position longitudinale x : $H_x(x)=\pm H_0$ pour x compris entre {0 - $\lambda/2$} modulo $\lambda$, et $H_x(x)=\mp H_0$ pour x compris entre {$\lambda/2$ - $\lambda$} modulo $\lambda$. A une distance a suffisante de la règle, on peut montrer facilement que le champ magnétique $H_x(x)$ est une fonction sinusoïdale de la position x, l'approximation du sinus s'améliorant lorsque la distance a augmente. La figure 1 illustre par des flèches la direction du vecteur de champ magnétique H(x) entre la règle et le capteur.

Le champ magnétique Ho à la surface de la règle est compris de préférence dans l'intervalle de 10 à 100 kA/m et décroît exponentiellement à une distance a de la surface selon la relation :

$$H_x(a)=H_0.e^{-2\pi a/\lambda}$$

Il est mécaniquement difficile de réaliser un système de mesure avec un capteur qui se déplace très près de la règle. Le coût du dispositif représente donc une contrainte pour la distance a entre le capteur et la règle. Les dispositifs magnétorésistifs de l'art antérieur étaient donc réservés à des appareils onéreux tels que colonne de mesure de hauteur, machine-outil ou microscope optique par exemple. Pour ce type de dispositifs, il est possible d'utiliser une mécanique suffisamment précise pour permettre de déplacer le capteur à une distance a de l'ordre de 0,1 millimètre de la règle. Nous verrons plus loin que le capteur de l'invention peut fonctionner à une distance de la règle a de l'ordre de 200 à 700μm, de préférence à 500μm, ce qui permet de l'utiliser dans des dispositifs portables de type pied à coulisse.

Lorsque la distance a entre la règle et le capteur égale la demi-période de règle $\lambda/2$, le champ magnétique H(a) ne représente déjà plus que 4% de la valeur du champ $H_0$ à la surface de la règle. Il est donc nécessaire d'utiliser une période de règle $\lambda$ suffisante pour récolter un champ magnétique suffisant sur le capteur 1. En réduisant $\lambda$, on obtient néanmoins l'avantage d'améliorer la forme sinusoïdale du champ magnétique $H_x(x)$ récolté à une distance a. La période de règle $\lambda$ choisie est donc nécessairement un compromis. Des essais ont montré que pour la distance a indiquée ci-dessus, des résultats optimaux sont obtenus avec une valeur de $\lambda$ entre 0,5 et 1,5 millimètres, de préférence 1 millimètre.

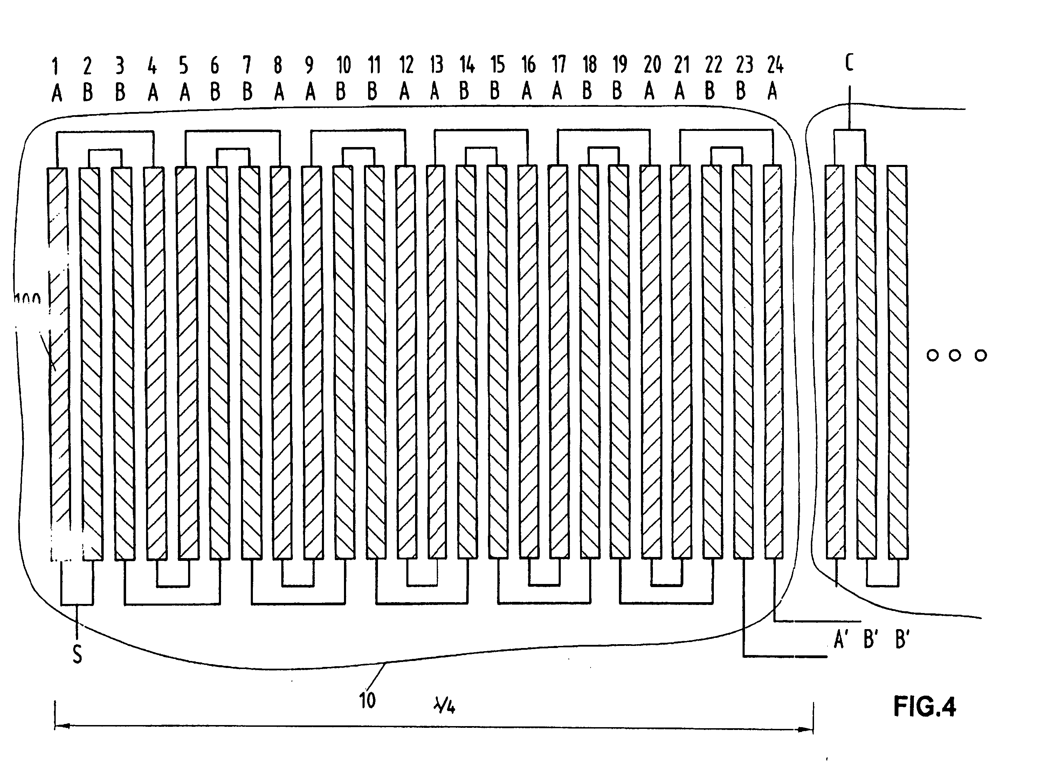

Le capteur 1 est muni d'électrodes magnétorésistives 100 (visibles en particulier sur la figure 4). Les électrodes magnétorésistives sont munies de structures de barberpole, c'est-à-dire de fines bandes parallèles de matériau conducteur inclinées de +-45° environ par rapport à l'axe des électrodes. La moitié des électrodes est munie de barberpoles orientés à +45° tandis que l'autre moitié est munie de barberpoles orientées à -45°. Il est possible de montrer qu'un champ magnétique H identique produit sur une électrode magnétorésistive munie de structure de barberpoles orientées à +45° une variation de résistance Δr opposée à celle produite sur une électrode magnétorésistive munie de structure de barberpole orientées à -45°.

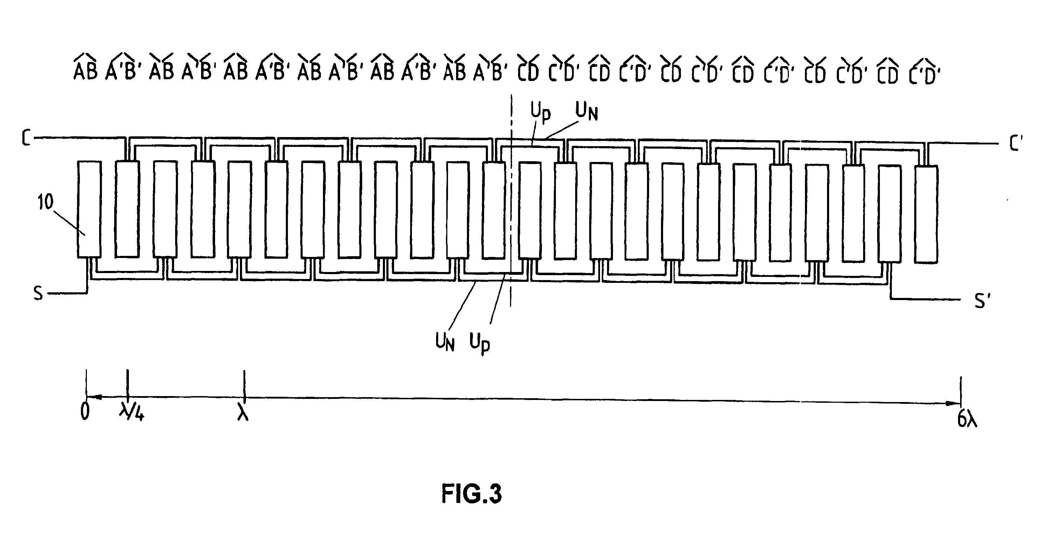

Les électrodes magnétorésistives 100 sont réparties longitudinalement sur le capteur 1 de manière à constituer x groupes 10, dans cet exemple 24 groupes d électrodes consécutives, dont seuls quelques-uns sont illustrés sur la figure 1. La disposition des 24 groupes d'électrodes magnétorésistives est illustrée sur la figure 3. Chaque groupe est constitué de y électrodes magnétorésistives 100 étalées sur une longueur w dans cet exemple 24 électrodes étalées Sur une longueur w égale à λ/4 soit 0,25 millimètres (voir figure 4). Le nombre total d'électrodes magnétorésistives 100 sur te capteur I est donc égal à xy = 24·24 = 576. Comme deux groupes successifs sont décalés de λ/4, le déphasage entre les signaux reçus par deux groupes successifs est de 90.

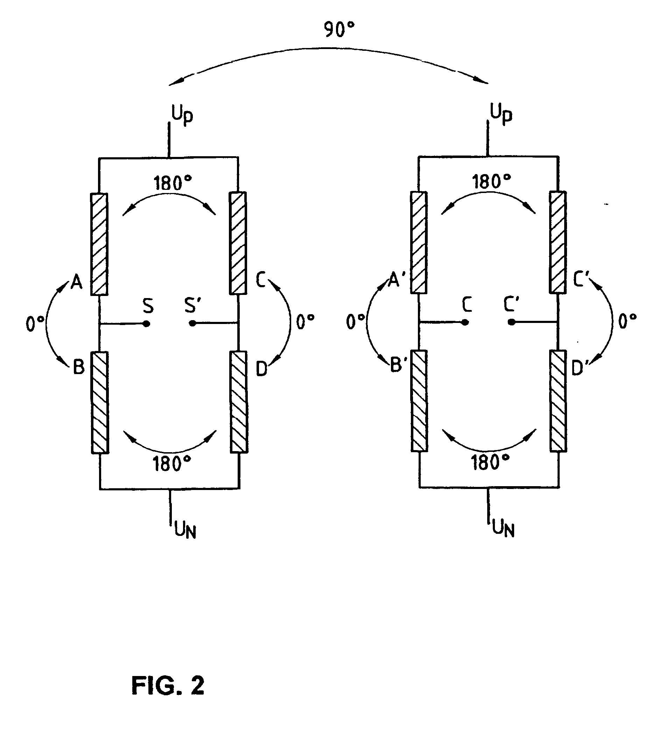

La figure 2 illustre la manière dont les différentes électrodes magnétorésistives 100 sur le capteur sont reliées de manière à définir deux ponts de mesure. Chaque pont de mesure comporte quatre branches, chaque branche étant constituée par un jeu d'électrodes magnétorésistives A, B, C, D et A'B'C'D'. Les deux ponts de mesure sont alimentés entre des tensions $U_P$ et $U_N$. Chaque jeu d'électrodes A, B, C, D, A', B', C', D' est constitué dans cet exemple par 72 électrodes reliées en série Si les électrodes magnétoréstives 100 ont une longueur de 1 millimètre environ et une largeur de l'ordre de 5 μm, il est possible d'obtenir avec des matériaux magnétorésistifs courants une résistance résultante élevée, supérieure à 10 10kΩ, de préférence supérieure à 50 kΩ, pour chaque jeu d'électrodes magnétorésistives et donc pour chaque pont. Les courants circulant à travers les deux ponts de mesure sont donc très faibles, ce qui permet de limiter la consommation électrique par rapport aux dispositifs de l'art antérieur et d'alimenter le capteur sur batterie par exemple.

Les quatre jeux A', B', C', D' du second pont A'B'C'D' proviennent des 12 groupes impairs, c'est-à-dire occupant des positions le long du capteur égales à λ/4, 3λ/2, etc. Les quatre jeux A, B, C, D du premier pont ABCD proviennent en revanche des 12 groupes pair, c'est-à-dire occupant des positions le long du capteur égales à 0, λ/2 etc. Le signal reçu à la sortie CC' du second pont est donc déphasé de 90° par rapport au signal reçu à la sortie SS' du premier pont.

Le tableau suivant résume la constitution des différents jeux d'électrodes A,B,C,D du premier pont et A', B', C', D' du second pont :

| Jeu du premier pont | Phase | Orientation des barberpoles | Jeu du second pont | Phase | Orientation des barberpoles |
|---|---|---|---|---|---|
| **A** | **0°** **180°** | **+45°** **-45°** | **A'** | **90°** **270°** | **+45°** **-45°** |
| **B** | **0°** **180°** | **-45°** **+45°** | **B'** | **90°** **270°** | **-45°** **+45°** |
| **C** | **0°** **180°** | **-45°** **+45°** | **C'** | **90°** **270°** | **-45°** **+45°** |
| **D** | **0°** **180°** | **+45°** **-45°** | **D'** | **90°** **270°** | **+45°** **-45°** |

Chaque jeu d'électrodes est constitué par un demi-jeu de 36 électrodes magnétorésistives occupant des premières positions de même phase et munies de structures de barberpole orientées selon une première direction, et par un second demi-jeu de 36 autres électrodes occupant des positions déphasées de 180° par rapport aux premières positions et munies de structures de barberpole orientées selon la seconde direction. La variation de résistance occasionnée par le champ magnétique $H_x(x)$ sur les deux demi-jeux est donc la même pour une position donnée x du capteur.

Le jeu d'électrodes B provient des mêmes groupes que le jeu d'électrodes A, l'orientation des structures de barberpole étant toutefois opposée. De la même façon, les jeux B', D et respectivement D' proviennent des mêmes groupes que les jeux A', C et respectivement C', l'orientation des structures de barberpole étant à chaque fois opposée. Les diviseurs de tension AB, CD et A'B', C'D' de chaque pont de mesure sont ainsi constitués par des électrodes magnétorésistives provenant de la même portion du capteur ; des variations locales de magnétisation de la règle sont ainsi compensées à l'intérieur même des ponts de mesure.

Les électrodes du jeu C occupent des positions déphasées de 180° par rapport aux électrodes du jeu A et partagent la même orientation des structures de barberpole. Il en va de même pour les électrodes des jeux D, C' et respectivement D' par rapport à celles des jeux B, A' et respectivement B'. Cet agencement est en particulier visible sur la figure 3, sur laquelle deux lettres et deux symboles / et \ indiquent au-dessus de chaque groupe les jeux d'électrodes qui le constitue ainsi que l'orientation des structures de barberpole choisie. Les structures de barberpole sont en outre directement indiquées sur les électrodes du groupe représenté sur la figure 4.

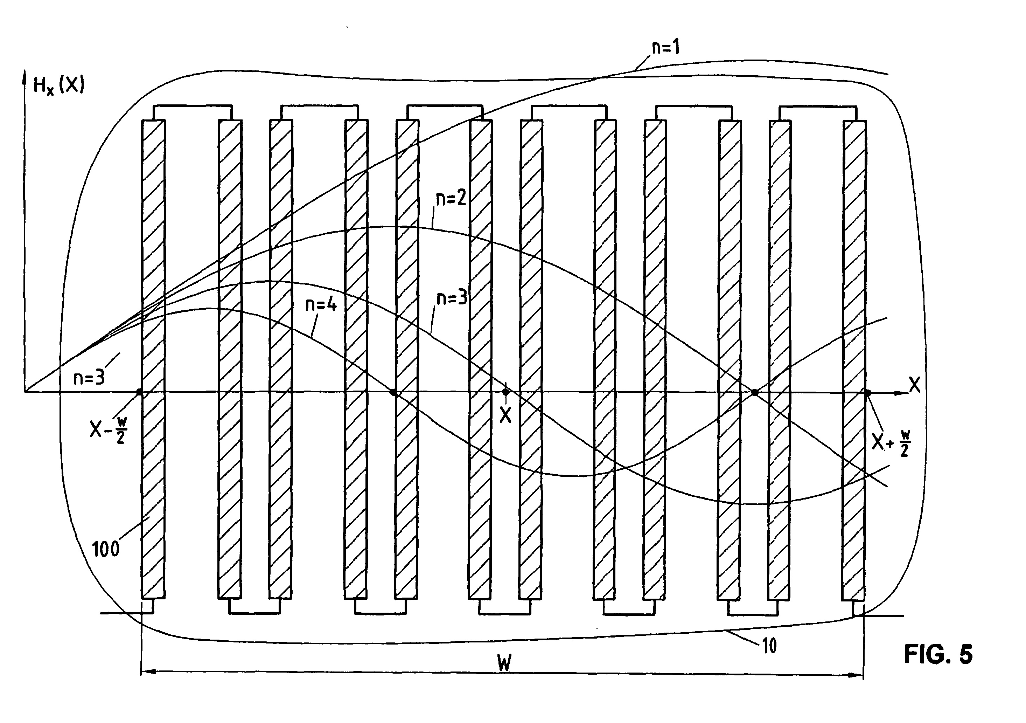

La résistance de chaque électrode magnétorésistive est fonction du champ magnétique $H_x(x)$ appliqué. Nous avons vu qu'à une distance a suffisante (0,5 millimètre ici), $H_x(x)$ est une fonction approximativement sinusoïdale et contient donc des harmoniques. La résistance R(x) de chaque électrode magnétorésistive 100 varie donc de manière approximativement sinusoïdale lorsque le capteur 1 se déplace dans le champ magnétique généré par la règle 2. La résistance de chaque jeu d'électrodes 100 dans l'un des ponts ABCD ou A'B'C'D' est égale à la somme de la résistance des 72 électrodes en série qui constituent ce jeu. Ces 72 électrodes sont réparties en 6 groupes qui occupent des positions de phase identiques (ou déphasées de 180°, mais avec une orientation opposée des barberpoles). La figure 5 représente les 12 électrodes magnétorésistives du même groupe 10 et du même jeu, ainsi que les quatre harmoniques principales n=1 à n=4 du champ $H_x$ produit par la règle sur chacune de ces 12 électrodes. La résistance R(x) de chaque jeu d'électrodes A à D' est égale à la résistance de 12 électrodes magnétorésistives 100 étalées sur une largeur w autour de la position x (modulo $\lambda/2$), multipliée par six (six groupes par jeu). La résistance d'un jeu d'électrodes tient donc compte de la valeur de $H_x(x)$ entre les positions [X-w/2 ; X+w/2]. On voit sur le dessin, et il est possible de démontrer aisément, que ce moyennage permet d'atténuer de manière importante les harmoniques de $H_x(x)$ : sur une longueur aussi importante que w=$\lambda/4$, les composantes positives et négatives des harmoniques d'ordre élevé se compensent. Ce moyennage permet donc d'améliorer la précision de la mesure. L'atténuation des harmoniques dépend de la largeur de moyennage : dans cet exemple, lorsque les groupes sont constitués de 24 électrodes reparties sur w=$\lambda/4$, l'atténuation de l'harmonique n=3 vaut environ 10 dB.

Pour un pas de règle $\lambda$ donné et une largeur des électrodes imposée par la technologie, il est donc avantageux d'utiliser des groupes constitués d'un grand nombre d'électrodes magnétorésistives afin d'augmenter l'étalement w des groupes et donc d'améliorer le moyennage du signal et la réduction des harmoniques.

L'augmentation du nombre d'électrodes par groupe peut également résulter de l'augmentation simultanée de l'étalement w des groupes et du pas de règle $\lambda$. Dans ce cas, sans perturber la forme sinusoïdale de $H_x(x)$ à la distance a, l'augmentation de $\lambda$ permet d'augmenter la valeur du champ magnétique $H_x$ au niveau des électrodes magnétorésistives, et donc leur sensibilité.

En gardant w et $\lambda$ constants, l'augmentation du nombre y d'électrodes par groupe peut être effectuée en réduisant leur largeur (dans les limites de la technologie utilisée). On parvient ainsi à augmenter leur résistivité, ce qui permet de réduire la consommation électrique du capteur. La réduction de largeur des électrodes étant compensée par l'augmentation de leur nombre, cette action n'a pas de conséquence tangible sur la sensibilité du dispositif.

Selon l'invention, le nombre y d'électrodes par groupe est donc volontairement important, en tous les cas supérieur à 8, dans l'exemple illustré égal à 24. Pour constituer deux ponts de mesure, 8 jeux d'électrodes sont nécessaires, qui doivent provenir de 4 groupes (au moins). Dans le cas où l'on décide d'utiliser n=2 ponts de mesure, on choisira donc un nombre x de groupes multiples de 4, par exemple 4, 8, 12, 16, 20, 24, 32, 36, 40 ou 48. Si l'on souhaite utiliser des demi-jeux d'électrodes, c'est-à-dire des jeux constitués d'électrodes avec deux orientations opposées des structures de barberpole, on se limitera à des valeurs x multiples de 8.

La figure 4 illustre à titre d'exemple un groupe 10 d'électrodes magnétorésistives 100 provenant d'un premier jeu A avec des barberpoles orientés à +45° et d'un second jeu B avec des barberpoles orientés à -45°. On notera que la succession choisie ABBAABBAABB.. etc.. permet d'une part d'assurer que le centre de gravité des électrodes de deux jeux, ici A et B, dans le même groupe se superpose, et d'autre part de relier toutes les électrodes entre elles sur un seul plan, sans croisements. Comme illustré sur la figure 3, les électrodes A, respectivement B, de ce groupe sont reliées en série avec les électrodes A, respectivement B, d'un groupe espacé de $\lambda/2$ et muni de barberpoles orientés à -45°, respectivement +45°. Aucun pont ou croisement n'est nécessaire pour relier les groupes 10 entre eux.

L'homme du métier pourra utiliser cette invention dans de nombreuses variantes adaptées à des besoins variés. En particulier, le nombre n de ponts de mesure utilisés peut être différent de 2 ; des mesures peuvent aussi être faites avec un seul pont de mesure, ou avec trois ponts déphasés de 120° par exemple. Dans ce dernier cas, il est par exemple possible de constituer des groupes d'électrodes étalés sur des longueurs w égales à $\lambda/3$, et comprenant donc encore davantage d'électrodes. En outre, en utilisant des structures de barberpole orientées avec des angles différents de +-45°, une grande liberté peut être gagnée pour répartir les groupes 10 sur le capteur et les électrodes 100 à l'intérieur des groupes 10. Enfin, notons également que les groupes d'électrodes peuvent aussi être constitués d'électrodes provenant d'un seul jeu, plutôt que de deux jeux entremêlés.

## Revendications

**1.** Capteur (1) destiné à être déplacé en regard d'une règle (2) magnétisée avec une période $\lambda$ pour mesurer des dimensions linéaires ou angulaires, muni d'électrodes magnétorésistives (100) reliées de manière à constituer n ponts de mesure (ABCD; A'B'C'D'), chaque pont de mesure comportant quatre jeux d'électrodes magnétorésistives (A, B, C, D, A', B', C', D'), arrangés pour former deux diviseurs de tension, chaque jeu d'électrodes constituant une branche d'un des ponts de mesure, les électrodes magnétorésistives de chaque jeu étant reliées en série;

dans lequel lesdites électrodes magnétorésistives (1) sont reparties longitudinalement sur le capteur (1) de manière à constituer une pluralité de groupes d'électrodes (10);

**caractérisé en ce que**

chaque groupe d'électrodes (10) comprend des électrodes magnétorésistives appartenant aux deux jeux d'un même diviseur de tension d'un desdits ponts de mesure (ABCD; A'B'C'D'), les deux jeux d'électrodes d'un diviseur de tension provenant du même groupe (AB, CD, A'B', C'D') portant des structures de barberpoles à orientations opposées.

2. Capteur (1) selon l'une des revendications précédentes **caractérisé en ce que** le nombre d'électrodes magnétorésistives de chaque groupe est supérieur à huit.

3. Capteur (1) selon l'une des revendications précédentes, **caractérisé en ce que** la résistance électrique de chaque jeu d'électrodes magnétorésistives (A, B, C, D, A', B', C', D') est supérieure à 10 kΩ, préférablement supérieure à 50 kΩ.

4. Capteur (1) selon l'une des revendications précédentes, **caractérisé en ce que** le nombre (x) de groupes d'électrodes magnétorésistives (10) est égal à 24, et **en ce que** le nombre (y) d'électrodes magnétorésistives par groupe (10) est égal à 24.

5. Capteur (1) selon l'une des revendications précédentes, **caractérisé en ce que** la largeur desdites électrodes magnétorésistives est inférieure ou égale à 5 μm et **en ce que** la longueur desdites électrodes magnétorésistives est supérieure ou égale à 1 mm.

6. Instrument de mesure de dimensions linéaires ou angulaires comprenant une règle (2) magnétisée avec une période λ et un capteur (1) selon l'une des revendications précédentes, le capteur (1) étant destiné à être déplacé relativement à ladite règle (2).

7. Instrument de mesure selon la revendication 6, dans lequel la distance entre ledit capteur (1) et ladite règle (2) est comprise entre 200 μm et 700 μm.

8. Instrument de mesure selon l'une des revendications de 6 à 7, dans lequel la période λ de la règle magnétisée (2) est comprise entre 0.5 mm et 1.5 mm.

9. Instrument de mesure selon l'une des revendications de 6 à 8, comprenant au moins une batterie pour alimenter ledit capteur (1).

**Patentansprüche**

1. Sensor (1), der dazu bestimmt ist, in Bezug auf einem mit einer Periode λ magnetisierten Lineal (2) bewegt zu werden zur Messung von linearen oder winkligen Dimensionen, versehen mit magnetoresistiven Elektroden (100), die verbunden sind, um n Messbrücken (ABCD; A'B'C'D') zu bilden, wobei jede Messbrücke vier Sätze von magnetoresistiven Elektroden (A, B, C, D, A', B', C', D') umfasst, die zur Bildung von zwei Spannungsteilern angeordnet sind, wobei jeder Elektrodensatz einen Zweig von einer der Messbrücken bildet, wobei die magnetoresistiven Elektroden von jedem Satz seriell verbunden sind,

worin besagte magnetoresistive Elektroden (100) längs auf dem Sensor (1) verteilt sind, so dass sie eine Vielzahl von Elektrodengruppen (10) bilden,

**dadurch gekennzeichnet, dass**

jede Elektrodengruppe (10) magnetoresistive Elektroden umfasst, welche den Sätzen vom gleichen Spannungsteiler eines der besagten Messbrücken (ABCD; A'B'C'D') angehören, wobei die zwei aus der gleichen Gruppe (AB, CD, A'B', C'D') stammenden Elektrodensätze eines Spannungsteilers mit Barberpole-Strukturen entgegengesetzter Richtungen versehen sind.

2. Sensor (1) gemäss dem vorhergehenden Anspruch, **dadurch gekennzeichnet, dass** die Anzahl von magnetoresistiven Elektroden jeder Gruppe grösser als acht ist.

3. Sensor (1) gemäss einem der vorhergehenden Ansprüche, **dadurch gekennzeichnet, dass** der elektrische Widerstand jedes Satzes von magnetoresistiven Elektroden (A, B, C, D, A', B', C', D') grösser als 10kΩ, vorzugsweise grösser als 50kΩ ist.

**4.** Sensor (1) gemäss einem der vorhergehenden Ansprüche, **dadurch gekennzeichnet, dass** die Anzahl (x) der Gruppen (10) von magnetoresistiven Elektroden gleich 24 und die Anzahl (y) der magnetoresistiven Elektroden pro Gruppe (10) gleich 24 ist.

**5.** Sensor (1) gemäss einem der vorhergehenden Ansprüche, **dadurch gekennzeichnet, dass** die Breite der besagten magnetoresistiven Elektroden kleiner als oder gleich 5μm und dass die Länge der besagten magnetoresistiven Elektroden grösser als oder gleich 1 mm ist.

**6.** Instrument zur Messung von linearen oder winkligen Dimensionen, umfassend ein mit einer Periode λ magnetisiertes Lineal (2) und einen Sensor (1) gemäss einem der vorhergehenden Ansprüche, wobei der Sensor (1) dazu bestimmt ist, in Bezug auf besagtem Lineal (2) bewegt zu werden.

**7.** Messinstrument gemäss Anspruch 6, worin der Abstand zwischen besagtem Sensor (1) und besagtem Lineal (2) zwischen 200μm und 700μm enthalten ist.

**8.** Messinstrument gemäss einem der Ansprüche 6 bis 7, worin die Periode λ des magnetisierten Lineals zwischen 0.5mm und 1.5mm enthalten ist.

**9.** Messinstrument gemäss einem der Ansprüche 6 bis 8, mit mindestens einer Batterie zur Speisung des besagten Sensors (1).

**Claims**

**1.** Sensor (1) designed to be displaced opposite a scale (2) magnetized with a period λ for measuring linear or angular dimensions, provided with magneto-resistive electrodes (100) connected so as to constitute n measuring bridges (ABCD; A'B'C'D'), each measuring bridge having four sets of magneto-resistive electrodes (A, B, C, D, A', B', C', D') arranged to form two voltage dividers, each set of electrodes constituting one branch of one of the measuring bridges, the magneto-resistive electrodes of each set being connected in series,
wherein said magneto-resistive electrodes (100) are distributed longitudinally on the sensor (1) so as to constitute a plurality of groups of electrodes (10);
**characterized in that**
each group of electrodes (10) comprises magneto-resistive electrodes belonging to the two sets of a same voltage divider of one of said measuring bridges (ABCD; A'B'C'D'), the two sets of electrodes of one voltage divider coming from the same group (AB, CD, A'B-, C'D') bearing barber-pole structures with opposed orientations.

**2.** Sensor (1) according to the preceding claim, **characterized in that** the number of magneto-resistive electrodes of each group is greater than eight.

**3.** Sensor (1) according to one of the preceding claims, **characterized in that** the electric resistance of each set of magneto-resistive electrodes (A, B, C, D, A', B', C', D') is greater than 10 kΩ, preferably greater than 50 kΩ.

**4.** Sensor (1) according to one of the preceding claims, **characterized in that** the number (x) of groups of electro-magneto-resistive electrodes (10) equals 24 and **in that** the number (y) of magneto-resistive electrodes per group (10) equals 24.

**5.** Sensor (1) according to one of the preceding claims, **characterized in that** the width of said magneto-resistive electrodes is lower than or equal to 5μm and **in that** the length of said magneto-resistive electrodes is greater than or equal to 1 mm.

**6.** Instrument for measuring linear or angular dimensions, comprising a scale (2) magnetized with a period λ and a sensor (1) according to one of the preceding claims, the sensor (1) being designed to be displaced relative to said scale (2).

**7.** Measuring instrument according to claim 6, wherein the distance between said sensor (1) and said scale (2) is comprised between 200 μm and 700 μm.

8. Measuring instrument according to one of the claims 6 to 7, wherein the period $\lambda$ of the magnetized scale (2) is comprised between 0.5 mm and 1.5 mm.

9. Measuring instrument according to one of the claims 6 to 8, comprising at least one battery for powering said sensor (1).

FIG. 1

EP 1 329 695 B1

**FIG. 2**

FIG.3

FIG.4

FIG. 5